(19) Europäisches Patentamt
European Patent Office
Office européen des brevets

(11) Publication number: 0 416 226 A1

# (12) EUROPEAN PATENT APPLICATION

(21) Application number: 90111659.0

(51) Int. Cl.5: H01L 29/90

(22) Date of filing: 20.06.90

(30) Priority: 08.09.89 US 404306

(43) Date of publication of application: 13.03.91 Bulletin 91/11

(84) Designated Contracting States: DE FR GB

(71) Applicant: Hewlett-Packard Company
Mail Stop 20 B-O, 3000 Hanover Street
Palo Alto, California 94304(US)

(72) Inventor: Tan, Michael R.
920 Tulane Drive
Mountain View, Calif. 94040(US)
Inventor: Wang, Shih Y.
766, Encina Grande
Palo Alto, Calif. 94306(US)

(74) Representative: Liesegang, Roland, Dr.-Ing. et al
FORRESTER & BOEHMERT
Widenmayerstrasse 4
W-8000 München 22(DE)

## (54) Double heterostructure step recovery diode.

(57) A step recovery diode (SRD) has at least one heterojunction. Such heterojunctions allow the fabrication of abrupt dopant profiles that improve the sharpness of a step function output signal from the SRD. Wider bandgap regions bound the intrinsic layer (55) of the SRD to reduce diffusion of charge carriers of the intrinsic region and to reduce diffusion of charge carriers produced outside of the region from diffusing into the intrinsic region.

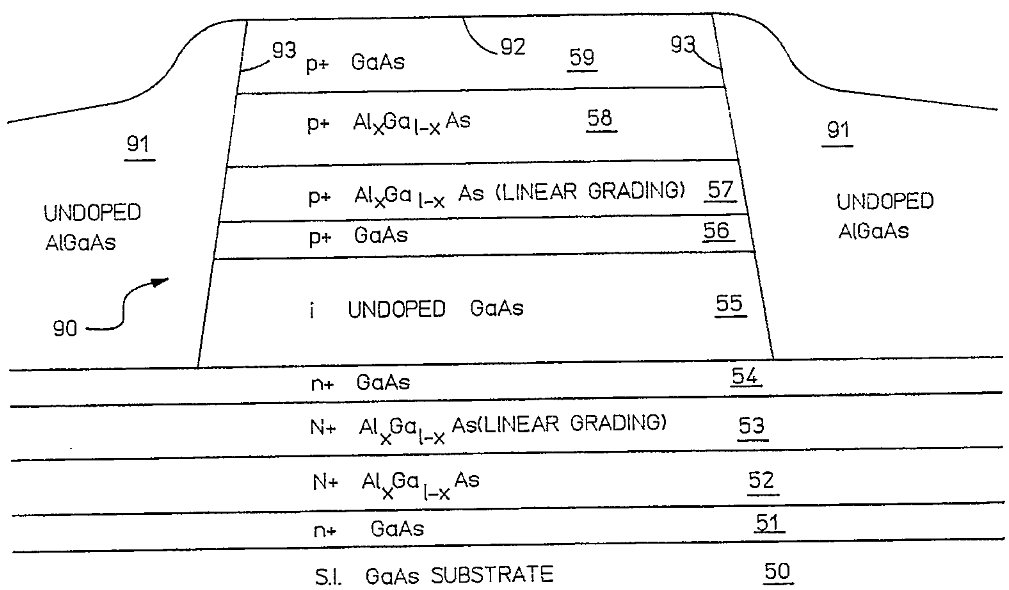


FIG_ 9

EP 0 416 226 A1

# DOUBLE HETEROSTRUCTURE STEP RECOVERY DIODE

The first digit of each reference numeral in this disclosure indicates the first figure in which the element designated by that reference numeral is presented.

## Background of Invention

This invention relates in general to step recovery diodes (SRD) and relates more particularly to double heterostructure step recovery diodes. SRDs are used extensively to produce pulses and other waveforms with extremely fast (less than 30 picoseconds) rise and fall times. SRDs are also commonly used in harmonic frequency multipliers because of their high efficiency in generating harmonics. Unlike photodiodes and lasers, a step recovery diode has: (1) abrupt doping profiles which produce abrupt carrier confinment; (2) a thin intrinsic layer; (3) an intrinsic layer with very long minority carrier lifetime to produce charge storage within the intrinsic layer; and (4) a voltage bias range that includes both forward and reverse bias during normal operation. "Abrupt" junctions are defined herein to be junctions that are on the order of one to a few atomic layers thick.

A step recovery diode is a practical realization of an ideal nonlinear capacitor. Such a capacitor has the capacitance (C) - voltage (V) characteristics illustrated in Figure 1. It is a device that has a large capacitance in the forward bias direction and a very small capacitance in the reverse bias direction. A preferred embodiment of an SRD is a $p^+$-i-$n^+$ diode with abrupt doping profiles between adjacent doped regions ($p^+$ region 21, intrinsic region 22 and $n^+$ region 23) as illustrated in Figure 2. In a silicon based embodiment, the $p^+$ region is about 5,000 Å thick and has a dopant concentration of about $10^{21}$ per $cm^3$. The intrinsic region 22 is less than 10,000 Å thick. The $n^+$ region is about 5,000 Å thick and has a dopant concentration of about $10^{20}$ per $cm^3$. Regions 21 and 23 are as heavily doped as possible in order to minimize minority carrier injection into these regions.

Under forward bias, both the $b^+$-i and i-$n^+$ junctions are forward biased and therefore inject into the intrinsic region large concentrations of holes and electrons, respectively. The minority carrier lifetime for holes and electrons in the intrinsic region 22 is relatively long (especially in a silicon-based intrinsic region) so that a respectively. The minority carrier lifetime for holes and electrons in the intrinsic region 22 is relatively long (especially in a silicon-based intrinsic region) so that a high concentration of electrons and holes (on the order of $10^{18}$ $cm^{-3}$) is produced in that region. This concentration of both types of carriers throughout the intrinsic region functions to store both type of carriers in that region and therefore functions as a bulk capacitor having a large diffusion capacitance. Under reverse bias, this diffuse charge concentration is drawn out of the intrinsic region toward the boundaries between the $p^+$ and i regions and between and i and $n^+$ regions. Such a charge distribution is substantially like that of a parallel plate capacitor. Thus, under reverse bias, the $p^+$-i-$n^+$ diode functions like a conventional parallel plate capacitor with a spacing between plates substantially equal to the thickness of the intrinsic layer. This reverse biased capacitance is substantially smaller than the forward biased capacitance.

The operation of the SRD as a step generator can be understood from the circuit diagram presented in Figures 3. A step recovery diode 31 is connected between a bias voltage source 32 and ground 33 to forward bias this step recovery diode initially. A pulse generator 34 consisting of a voltage source 35 and a standard source impedance 36 of 50 ohms produces a voltage step function (illustrated by curve (a) of Figure 3). This voltage step function is applied across step recovery diode 31 to apply reverse bias. A pair of capacitors 37 and 38 provide dc isolation of the step recovery diode from the rest of the circuit. A resistor 310 of known impedance between step recovery diode 31 and dc bias voltage source 32 determines the forward dc current drawn from this dc voltage source.

When current through step recovery diode 31 switches at time $t_1$ from forward to reverse current, the voltage drop across step recovery diode 31 remains small because the relatively large concentration of stored carriers in the intrinsic region 22 produces a relatively low impedance across the SRD. Therefore, in the period from $t_1$ to $t_2$, the impedance experienced by voltage source 35 is substantially constant at the source impedance of resistor 36. Therefore, the current plot (b) in this time period varies substantially linearly with the applied voltage shown in plot (a). This relatively high conductivity of SRD 31, due to the stored carriers in the intrinsic layer, substantially shorts the output signal $E_0$ at output port 311 so that $E_0$ is substantially zero up to time $t_2$ (see plot (c)).

During the interval from $t_1$ to $t_2$, voltage E acts so as to build up a large electric field in intrinsic region 22 of SRD 31, which then produces a drift of holes toward and into $p^+$ region 21 and producing a drift of electrons toward and into $n^+$ region 23. In

the transition time $t_t$ from $t_2$ to $t_3$, the tail end of the distributions of holes and electrons exits from intrinsic region 22 resulting in a sharp increase in the resistivity of intrinsic region 22. Ideally, once all the stored charge is removed from the intrinsic region, the current flowing through the diode transitions to a small reverse current which is due to thermally generated electron-hole pairs in the intrinsic layer (i.e., space-charge limited). This, in turn, produces a sharp transition in the output voltage $E_0$. Because of this, the step transition of the output signal $E_0$ is much sharper (i.e., shorter in time) than the step transition in the applied step voltage E.

The speed with which the diode transitions from the initial large reverse current to the small space-charge limited current depends on the device structure and the external circuit that it interacts with. The dependence of the transition time on the device structure was previously described in Moll et. al., **Proc IEEE**, Vol 57, No. 7, July 1969. In their paper, they showed that the transition time is dependent on several factors:

(i) the transit time $T_t$ of the minority carriers through the intrinsic layer, which in turn is determined by the saturated drift velocity of the minority carriers through the intrinsic layer and the width of the intrinsic region;

(ii) the RC time constant $T_{RC}$, where R is the parallel combination of the source resistance 36 and the load resistance 312 and where C is the reverse bias capacitance of the SRD;

(iii) the amount of injected minority carrier diffusion into the $p^+$ and $n^+$ regions; and

(iv) the abruptness of the doping profile gradings from the $p^+$ region to the intrinsic region and from the $n^+$ to i region.

The interval from $t_1$ to $t_2$ is largely determined by the minority carrier lifetime and the magnitude of the forward bias current. The minimum transition time $t_R$ (i.e., from $t_2$ to $t_3$) is approximately equal to $[T_t^2 + T_{RC}^2]^{1/2}$. This transition time is also the minimum width of a pulse that can be produced by such SRDs and therefore the inverse of this transition time determines the absolute upper bound of the pulse repetition rate that can be produced (See the Figure 2 at page 1251 in the Moll reference mentioned above). Therefore, when such a circuit is utilized in a sampler, this interval determines the maximum sampling rate. Factors (iii) and (iv) affect the duration between $t_2$ and $t_3$ and therefore affect the steepness of the transition in $E_0$, which in turn controls the minimum width of a sampling pulse in a sampling circuit. Significant injected minority carrier diffusion and nonabrupt doping profiles both broaden the width of the trailing edge of the carrier distribution being swept out of the intrinsic region 22 and therefore broaden the step transition in output signal $E_0$. Preferably, these doping profiles are as abrupt as possible.

## Summary of the Invention

Figure 2 illustrates the structure of a typical existing $p^+$-i-$n^+$ homojunction step recovery diode. Figures 4A-4D show simulation results for the homojunction SRD fabricated on GaAs. Figure 4A shows the energy band diagram of the SRD at high forward bias $V_F$ = 1.4 V. Figure 4B shows electron and hole concentrations within the SRD at this forward bias. In Figure 4C is shown the energy band diagram of the same SRD at a reverse bias of $V_R$ = -5 V. In Figure 4D is shown the corresponding carrier concentration in the reverse biased SRD.

Figure 4B shows that the injected minority carrier concentration in the intrinsic layer can be as high as $10^{18}$ $cm^{-3}$. At this high carrier concentration, the major recombination mechanism in a direct bandgap material like GaAs is radiative. This limits the minority carrier lifetime in the intrinsic region to several nanoseconds and therefore reduces the bulk charge storage in the intrinsic region under forward bias of the SRD. This limits the total charge in the intrinsic region and hence reduces the forward biased capacitance of such an SRD.

Figure 4B also illustrates the large injected minority carrier diffusion into the $n^+$ and $p^+$ regions even though they are each doped to on the order of $10^{19}$ $cm^{-3}$. Such large minority carrier diffusion causes a severe degradation in the transition time of the SRD with increasing forward bias because such minority carrier distribution then extends to an undesired distance into the $n^+$ and $p^+$ regions, thereby increasing the effective thickness of the intrinsic region. As previously discussed, this increases the time needed to sweep out the forward bias stored charge, thereby degrading the transition time of this SRD. Therefore, both the $n^+$ and $p^+$ regions are doped with the highest concentration possible in order to minimize minority carrier injection into the $n^+$ and $p^+$ regions.

Presently, SRDs are fabricated on silicon using vapor phase epitaxy, ion beam implantation and diffusion techniques. The p-i-n structure of Figure 2 produced by these techniques exhibits an intrinsic region width greater than 0.5 microns and exhibits p-i and i-n dopant level transitions greater than 0.25 microns. In addition, the minority carriers in the intrinsic region 22 diffuse into the $p^+$ and $n^+$ regions to a diffusion length on the order of several microns, depending on dopant concentration. Both of these effects broaden the effective width of the intrinsic region. As a result of this, the step transition in the output signal $E_0$ is on the order of 30 ps.

In accordance with the illustrated preferred embodiment, these times are reduced by producing sharper doping transitions (factor (iv) above) by manufacturing the p-i-n type step recovery diode as a heterostructure device. The transit time $T_t$ - (factor (i) above) is also reduced by reducing the width of the intrinsic region from the typical width of 1 micron in present step recovery diodes to less than 0.5 microns in these new step recovery diodes. Since the RC time constant $T_{RC}$ (factor (ii) above) increases inversely with the width of the intrinsic region, in this new device, the intrinsic region width is selected such that $T_{RC} = T_t$.

The new SRD is a double heterostructure $p^+$-$P^+$-i-$N^+$-$n^+$ or $p^+$-$P^+$-$p^+$-i-$n^+$-$N^{-+}$-$n^+$ device, where the capital letters are used to denote material having a wider bandgap than those materials designated by lower case letters. These wider bandgap regions present potential barriers for both holes and electrons injected into the intrinsic region i. These barriers help to confine the injected minority carriers to the intrinsic layer (see, for example, Casey and Panish, "Heterostructure Lasers Part A: Fundamental Principles", Chapter 4) and thereby reduce the amount of diffusion of minority carriers out into the $p^+$ and $n^+$ regions. This addresses factor (iii) discussed above.

The level of injected minority electron diffusion into the wide bandgap $P^+$ region is reduced by a factor of

$$e^{-\Delta E_c/kT} \text{ where } \Delta E_c$$

is the conduction band discontinuity experienced in going from the narrow to wide bandgap material. Similarly, the level of injected minority hole diffusion into the wide bandgap $N^+$ is reduced by a factor of

$$e^{-\Delta E_v/kT} \text{ where } \Delta E_v$$

is the valence band discontinuity experienced in going from the narrow to wide bandgap material.

The potential barriers introduced by the wide bandgap regions also reduce problems produced by photogenerated carriers in a direct bandgap material. Such photogenerated carriers can have a significant effect in SRDs manufactured in a direct bandgap material. In a direct bandgap material, the conduction band has a minimum, as a function of wavenumber, that is centered over the maximum of the valence band. Therefore, the radiative transitions, which take place between the minimum of the conduction band and the maximum of the valence band do not require any change in wavenumber k value and therefore do not require an associated phonon to be generated. This increases the electron-hole recombination rate compared to indirect bandgap materials and therefore also increases the rate of photogeneration. In such materials, holes and electrons in the intrinsic region can readily recombine producing a photon that can be absorbed in the $p^+$ and/or $n^+$ regions in the SRD producing an electron-hole pair. This increases the minority carrier concentration in the $p^+$ and $n^+$ regions thereby increasing the transition time of the SRD.

In the increased bandgap regions, the bandgap is larger than the energy of the photons generated by electron-hole pair recombination in the lower bandgap intrinsic region and therefore the wider bandgap regions are transparent to such photons. Therefore, absorption of such recombination generated photons only occurs in the $p^+$ and $n^+$ contact regions. The wider bandgap regions produce as potential barriers that prevent such photogenerated carriers from diffusing back to the intrinsic region. This confinement of the photogenerated carriers to the contact regions causes them to either recombine nonradiatively in the contact regions or to experience secondary photon generation and self-absorption process. The number of secondary photons is much smaller than the number of primary photons because the product of the electron and hole concentrations in the $p^+$ and $n^+$ contact regions is much smaller than in the intrinsic region under forward bias.

Further improvement of the present step recovery diode design is to bury the SRD in undoped high bandgap material. Such an embodiment is illustrated in Figure 9. In this embodiment, a structure such as in Figure 5 is etched down to the bottom of the intrinsic layer to produce a mesa structure 90. Undoped AlGaAs 91 is then deposited to form the structure of Figure 9.

It is well known that injected carriers recombine at semiconductor surfaces resulting in a nonuniform distribution of injected carriers throughout the SRD. This results in an increase in the transition time since all of the stored injected carriers are not swept out simultaneously during the transition period. Also there is a decrease in the total number of stored charge due to surface recombination. This increased recombination manifests into a shorter minority carrier lifetime lowering the forward bias diffusion capacitance. By burying the SRD in undoped wide bandgap material the surface recombination can be reduced by several orders of magnitude as discussed in Nelson et al. "Interfacial Recombination Velocity in AsGaAs/GaAs Heterostructures", **Appl. Phys. Lett.,** 32(11), 1 June 1978.

In existing SRDs like that in Figure 2, step transitions on the order of 35 picoseconds with amplitudes less than 15 volts can be produced. In the improved SRD of Figure 5, step transitions on the order of 10 picoseconds and amplitudes less than 12 volts are possible. Thus the new SRDs offer a factor of 3-4 improvement in transition time.

## Description of the Figures

Figure 1 illustrates the capacitance-voltage characteristics of a conventional step recovery diode.

Figure 2 illustrates the structure of a conventional step recovery diode.

Figure 3 illustrates the operating properties of a conventional step recovery diode.

Figures 4A and 4C show the simulation results of the energy band diagram of a convention step recovery diode under a 1.4 volt forward and 5 volt reverse bias, respectively.

Figures 4B and 4D show the simulation results of the electron and hole concentrations in a conventional step recovery diode under a 1.4 volt forward and 5 volt reverse bias, respectively.

Figure 5 illustrates the preferred embodiment of a double heterostructure step recovery diode.

Figures 6A, 7A and 8A show simulation results of the energy band diagrams of the GaAs/$Al_xGa_{1-x}As$ double heterostructure step recovery diode of Figure 5 under zero bias, 1.4 volt forward bias and 5 volt reverse bias, respectively.

Figures 6B, 7B and 8B show simulation results of the electron and hole concentration diagrams of the GaAs/$Al_xGa_{1-x}As$ double heterostructure step recovery diode of Figure 5 under zero bias, 1.4 volt forward bias and 5 volt reverse bias, respectively.

Figure 9 illustrates the structure of a buried step recovery diode.

## Description of the Preferred Embodiment

Figure 5 illustrates the preferred embodiment of a double heterostructure step recovery diode for the case of GaAs low bandgap material and $Al_xGa_{1-x}As$ (x on the order of 0.2) wide bandgap material. As indicated below, other material choices can be utilized to produce this structure. This step recovery diode includes low bandgap regions 50, 51, 54, 55, 56, and 59, wide bandgap regions 52 and 58 and graded bandgap regions 53 and 57. This structure can be produced by a wide variety of techniques including Molecular Beam Epitaxy (MBE), Chemical Beam Epitaxy (CBE), Organo-Metallic Vapor Phase Epitaxy (OMVPE) and Limited Reaction Process (LRP). There are many choices of dopants including Si, Te, Sn for n-type dopants and Be and C for p-type dopants.

Region 55 is the intrinsic region in which bulk storage of both types of minority carriers occurs under forward bias of the SRD. Wide bandgap regions 52 and 58 produce potential barriers to electrons and holes that provide beneficial confinement of minority carriers as discussed in detail below. Regions 51 and 59 are contact regions that enable formation of good ohmic contacts to metallic contacts. Various physical structures for forming metal contacts in physical contact with regions 51 and 59 are well known.

Graded bandgap regions 53 and 57 avoid dipole layer formation between layers 52 and 54 and between layers 56 and 58. In other embodiments, graded regions 53 and 57 can be omitted so that wider bandgap regions 52 and 58 are respectively bounded by abrupt junction at junctions 510-513. Extremely thin (less than 200Å) lower bandgap doped layers 54 and 56 between wider bandgap regions 53 and 57 and intrinsic region 55 are needed to provide a good transition from the wide bandgap regions 53 and 57 to the intrinsic region 55. Omission of these layers may result in poor injection into the intrinsic region due to recombination at the heterojunction interface. This recombination is caused by interface states produced by defects normally present at a heterojunction.

These pulse doped regions also compensate for the lower free carrier concentration in the wide bandgap regions (see, for example, Casey and Panish, Heterostructure Lasers Part A: Fundamental Principles, Chapter 4 or HP Technical Memo: 85-HDL-11) caused by the higher donor activation energy in n-type $Al_xGa_{1-x}As$ than that existing in the lower bandgap GaAs.

Figures 6A, 7A and 8A show simulation results of the energy band diagrams of the GaAs/$Al_xGa_{1-x}As$ double heterostructure step recovery diode of Figure 5 under zero bias, 1.4 volt forward bias and 5 volt reverse bias, respectively. Figures 6B, 7B and 8B show simulation results of the electron and hole concentration diagrams of the GaAs/$Al_xGa_{1-x}As$ double heterostructure step recovery diode of Figure 5 under zero bias, 1.4 volt forward bias and 5 volt reverse bias, respectively. These figures show that the $P^+$-$p^+$-i structure acts as a good potential barrier to injection of electrons from the intrinsic region into the $p^+$ region and that the i-$n^+$-$N^+$ acts as a good potential barrier to injection of holes from the intrinsic region into the $n^+$ region. In particular, Figure 7B shows that there is good minority carrier confinement to the intrinsic region i under forward bias conditions.

Figure 7B also exhibits a several orders of magnitude decrease in minority carrier injection into the wide bandgap regions from the intrinsic region i, compared to the minority carrier injection into the $n^+$ and $p^+$ regions in the prior art pin SRD of Figure 2. This decrease is equal to

$$e^{-\Delta E_c/kT}$$

for region 58, where $\Delta E_c$ is the bandgap discontinuity at the heterojunction interface 510. Similarly, this decrease is equal to

$$e^{-\Delta E_v/kT}$$

for region 52, where $\Delta E_v$ is the bandgap discontinuity at the heterojunction interface 511. This shows that the wide bandgap regions limit the minority carrier injection from the intrinsic region 55 into the $n^+$ and $p^+$ contact regions, thereby producing a transition time predominantly determined by the thickness T of the intrinsic region.

For SRDs fabricated on a direction bandgap semiconductor such as GaAs and AlGaAs, the dominant recombination mechanism is radiative. That is electron-hole pairs predominantly recombine to generate photons with energies close to the bandgap energy. Some of these photons are reabsorbed thereby generating electron-hole pairs elsewhere in the semiconductor (see, for example, Dumke, Spontaneous Radiative Recombination in Semiconductors, **Phys. Rev.,** Vol 105, No. 1, January 1957). Cladding the intrinsic region with wider bandgap material that is transparent to the bandgap radiation results in a separation of the photon generated minority carriers from intrinsic layer since they can only be reabsorbed in the $n^+$ and $p^+$ contact regions. The minority carriers produced by such reabsorption can recombine either nonradiatively in the $p^+$ or $n^+$ contact layers or can recombine radiatively in another secondary photon generation and self-absorption process. The number of photons regenerated in the SRD contact regions 51 and 59 of the double heterojunction SRD of Figure 5 is drastically reduced compared to the number of photons regenerated in the SRD contact regions 21 and 23 of the pin SRD of Figure 2 because of the greatly reduced minority carrier concentrations in the $p^+$ and $n^+$ contacts layers of the double heterojunction SRD of Figure 5 compared to that of the SRD of Figure 2. The doped transition regions 54 and 56 must be kept thin (i.e. much less than the absorption length, $\alpha^{-1}$ of recombination generated photons in those layers) to minimize photon absorption by these two layers since the resulting carriers are not barred from the intrinsic region 55 as are the photogenerated carriers in contact regions 51 and 59.

Other choices of materials can be selected to form the double heterojunction SRD. These other choices include other III-V material systems and II-VI material systems. A choice that is particularly suitable of the double heterojunction SRD is the $Si/Ge_xSi_{1-x}/Si$ material system. In such devices, silicon is the wider bandgap material and $Ge_xSi_{1-x}$ is the lower bandgap material. This material system the following advantages over the III-V material systems:

1) this system exhibits an indirect bandgap so that there is an increased minority carrier lifetime thereby increasing the forward biased capacitance of such an SRD;

2) only nonradiative recombination mechanisms are important so that photon generation and self-absorption will not be a significant factor in such SRDs;

3) silicon is easily passivated by oxidizing the top surface to produce an $SiO_2$ passivation layer that significantly reduces the amount of surface recombination; and

4) higher doping densities for both n- and p-type materials are possible.

However, there is no good semi-insulating substrate on which to grow the $Si/Ge_xSi_{1-x}/Si$ material system. Therefore, such a system exhibits increased parasitic capacitances. However, the Silicon-On-Sapphire process can be used to epitaxially grow a silicon layer on an insulating sapphire substrate. This enables the production of SRDs with reasonable parasitic capacitances. The relatively decreased minority carrier lifetime results from the large number of defects found in material grown on SOS substrates. Another problem is the lattice mismatch (pseudomorphic) between silicon and $Ge_xSi_{1-x}$ because this generally limits the thickness of a $Ge_xSi_{1-x}$ intrinsic layer to a few thousand angstroms and can also reduce the minority carrier lifetime.

## Claims

1. A step recovery diode **characterized** by
an intrinsic region (55) of a first material;
a highly doped p-type region (58), of a second material different from the first material, connected to the intrinsic region;
a highly doped n-type region (52), of a third material different from the first material, connected to the intrinsic region (55), whereby abrupt junctions can be formed between regions to produce at such junctions an abrupt change in free carrier concentrations.

2. A step recovery diode as in claim 1, wherein the second and third materials are the same.

3. A step recovery diode as in claim 1 or 2, wherein the second material has a wider bandgap than the first material.

4. A step recovery diode as in claim 1 or 3, wherein the third material has a wider bandgap than the first material.

5. A step recovery diosde as in one of the preceeding claims, wherein the said p- and/or n-type region is bounded by a pair of abrupt junctions.

6. A step recovery diode as in one of the preceeding claims further comprising, between the p- and/or n-type region (58, 52) and the intrinsic region (55) a region (57, 53) that provides a continuous grading in composition from the intrinsic region to the p-and/or n-type region.

7. A step recovery diode as in one of the preceding claims further comprising, between the p- and/or n-type layer and the intrinsic region, a p- and/or n-type region of the same material as the intrinsic region.

8. A step recovery diode as in one of the preceeding claims, wherein said p- and/or n-type region has a width less than the absorption length of that region for photons generated by charged carrier recombination within the intrinsic region.

9. A step recovery diode as in one of the preceeding claims wherein said first and second or third materials are selected from the class consisting of: GaAs first material and $Al_xGa_{1-x}$ As second or third material; $Ge_xSi_{1-x}$ first material and Si second or third material; and $Ge_xSi_{1-x}$ first material and Si second material formed on a sapphire substrate.

10. A step recovery diode as in claim 1 wherein the intrinsic region (5) and the p- and/or n-doped regions form a mesa, having a top surface (92) and sides (93), on top of all n- and/or p-doped regions, said diode further comprising an undoped region that covers all n-and/or p-doped regions and the sides of the mesa.

11. A step recovery diode as in one of the preceeding claims wherein the first and one of the second and third materials form an abrupt heterojunction.

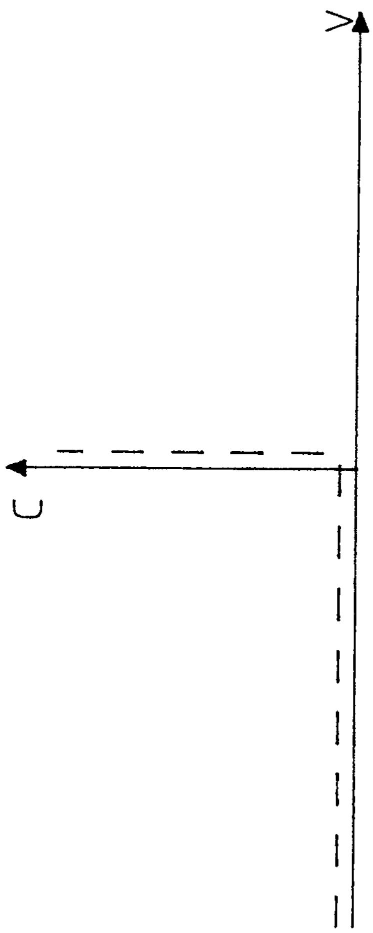


FIG_ 1 (PRIOR ART)

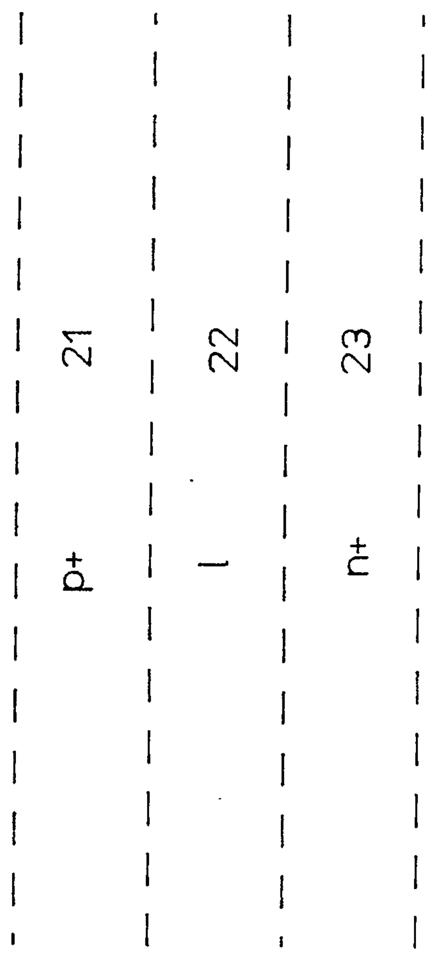


FIG_ 2 (PRIOR ART)

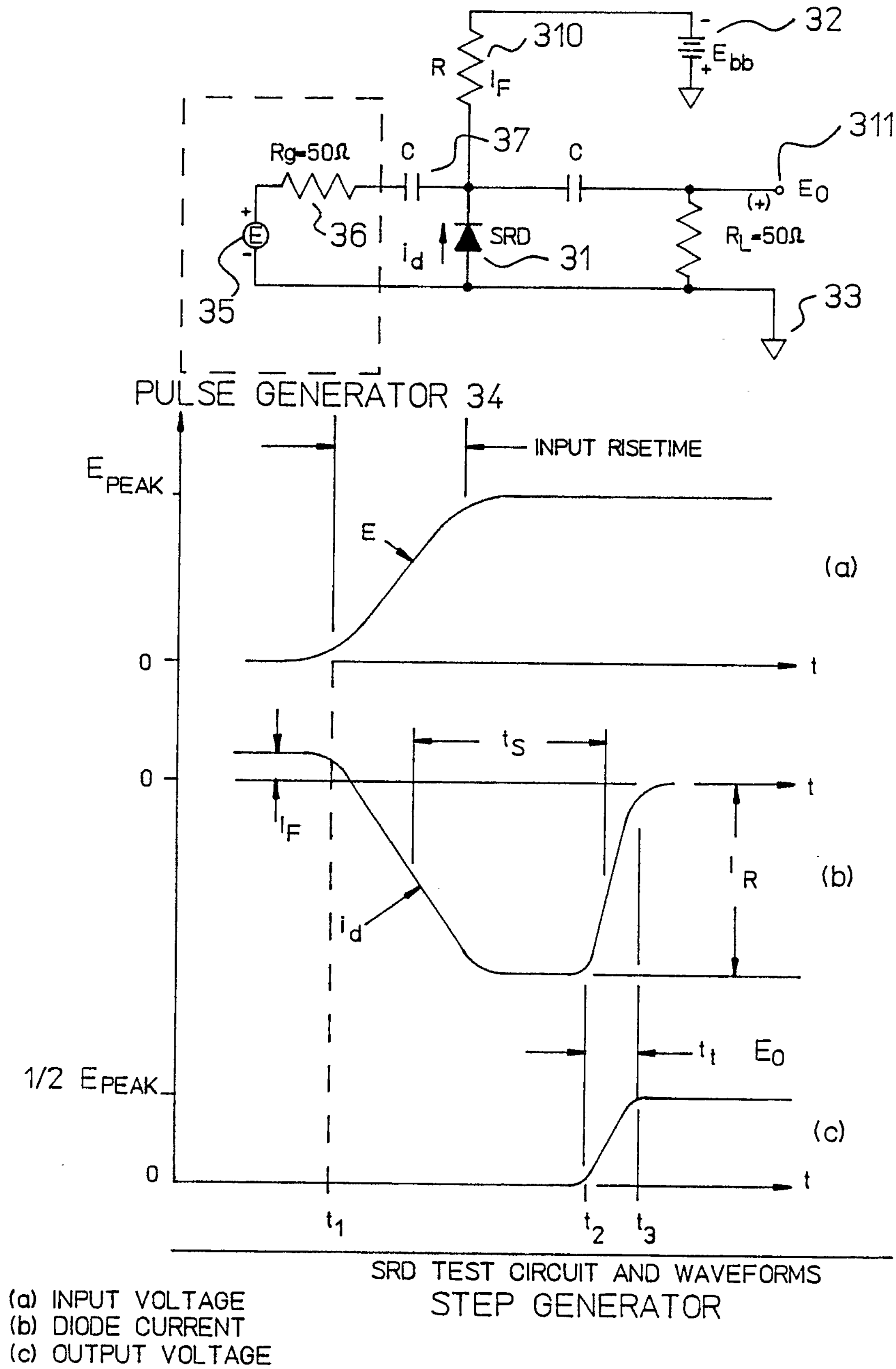


**FIG_ 3** (PRIOR ART)

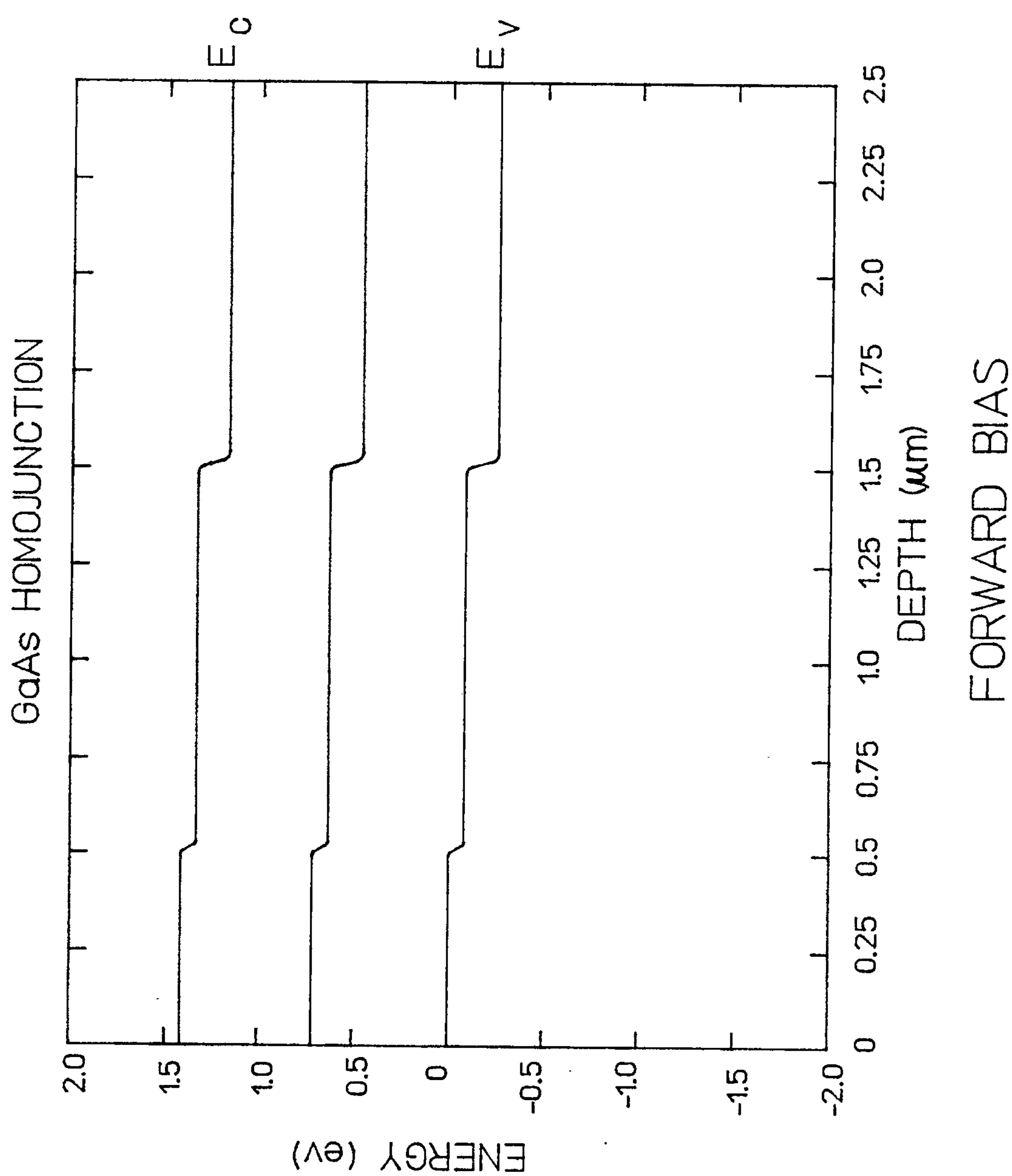
GaAs HOMOJUNCTION
E C
E V
ENERGY (ev)
2.0
1.5
1.0
0.5
0
-0.5
-1.0
-1.5
-2.0
0
0.25
0.5
0.75
1.0
1.25
1.5
1.75
2.0
2.25
2.5
DEPTH (μm)
FORWARD BIAS

FIG_ 4A

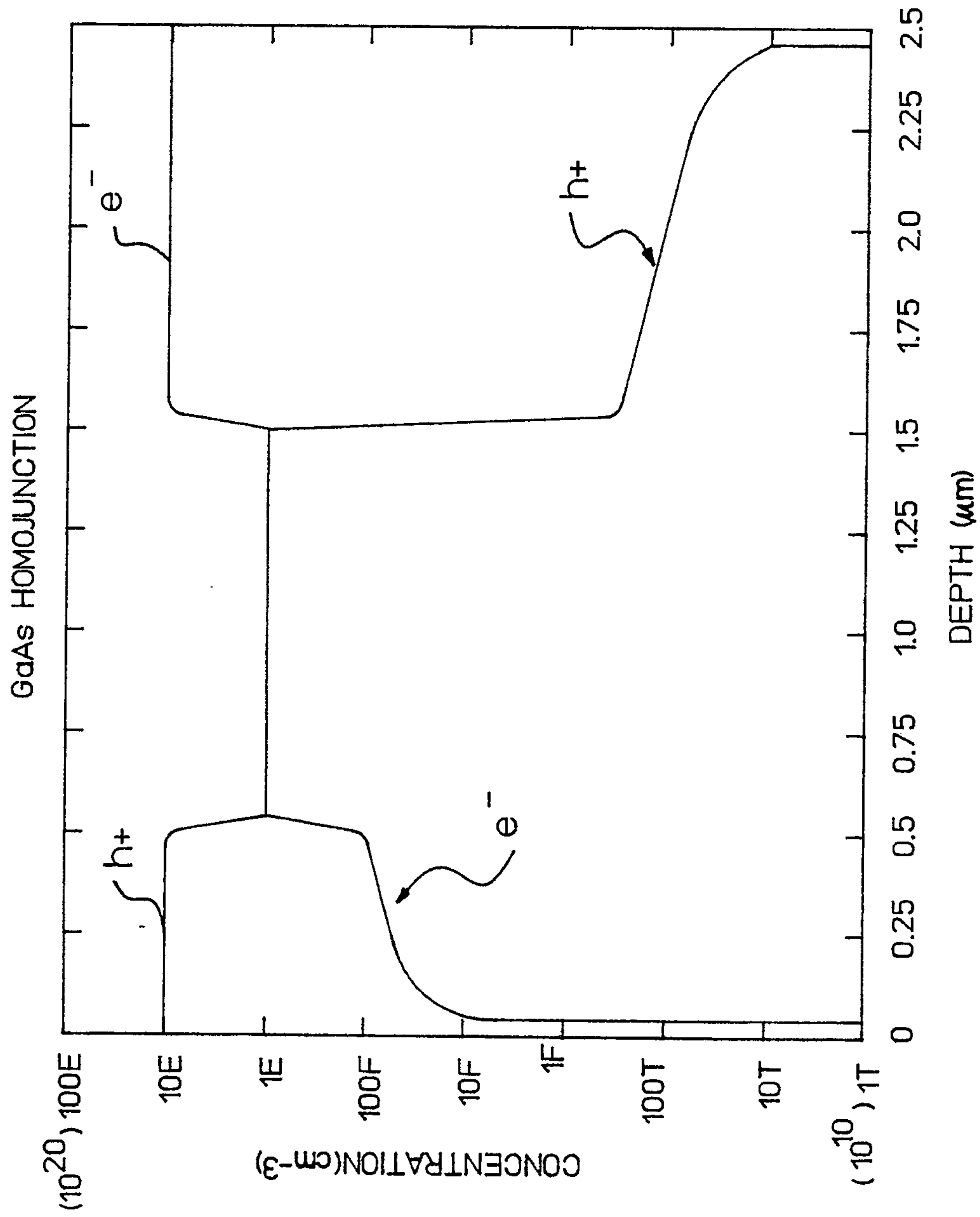
GaAs HOMOJUNCTION
CONCENTRATION(cm-3)
$(10^{20})$ 100E
10E
1E
100F
10F
1F
100T
10T
$(10^{10})$ 1T
DEPTH (μm)
0
0.25
0.5
0.75
1.0
1.25
1.5
1.75
2.0
2.25
2.5
h+
e⁻
e⁻
h+

FIG_ 4B

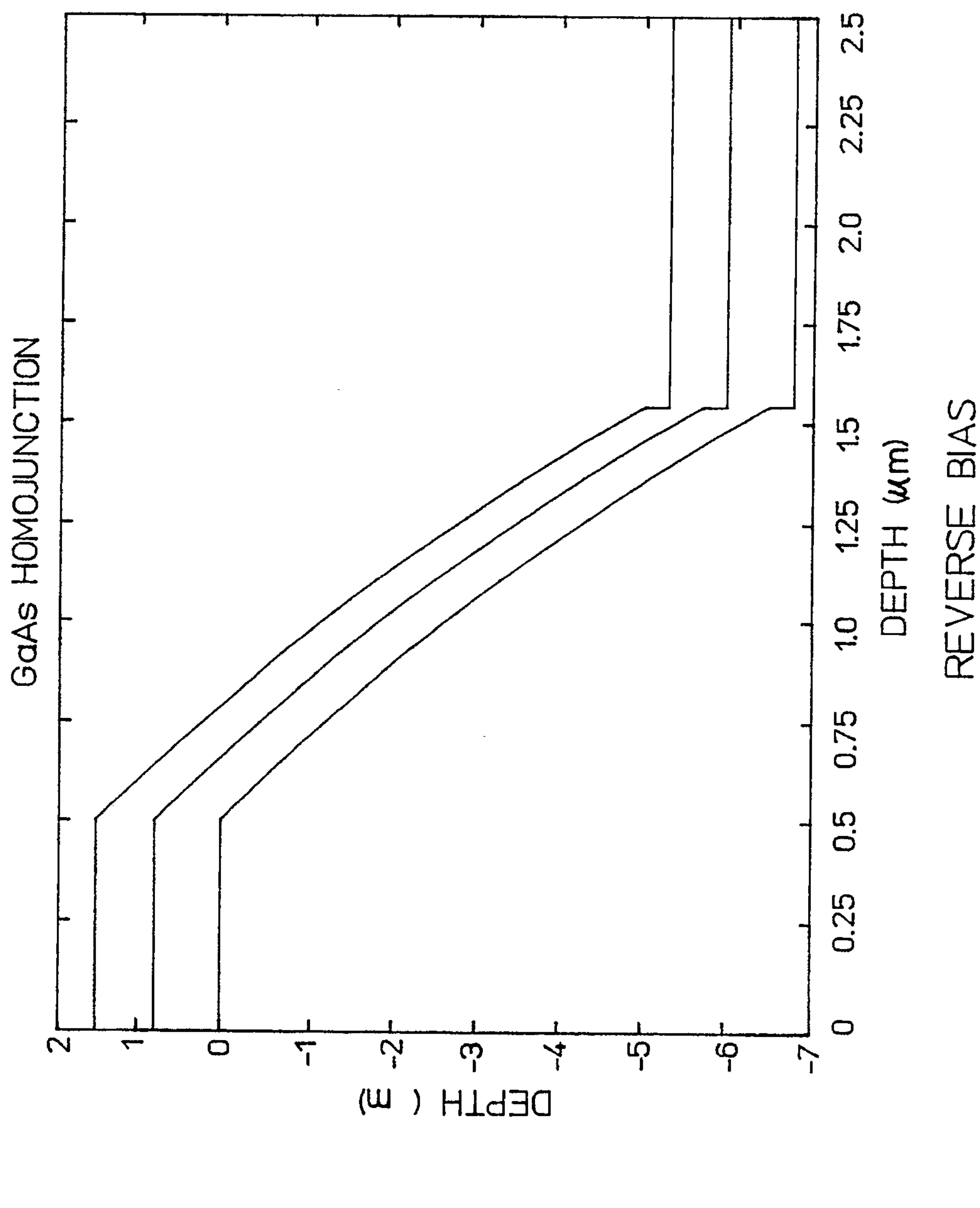
GaAs HOMOJUNCTION
2
1
0
-1
-2
-3
-4
-5
-6
-7
DEPTH ( m)
0
0.25
0.5
0.75
1.0
1.25
1.5
1.75
2.0
2.25
2.5
DEPTH (μm)
REVERSE BIAS

FIG_ 4C

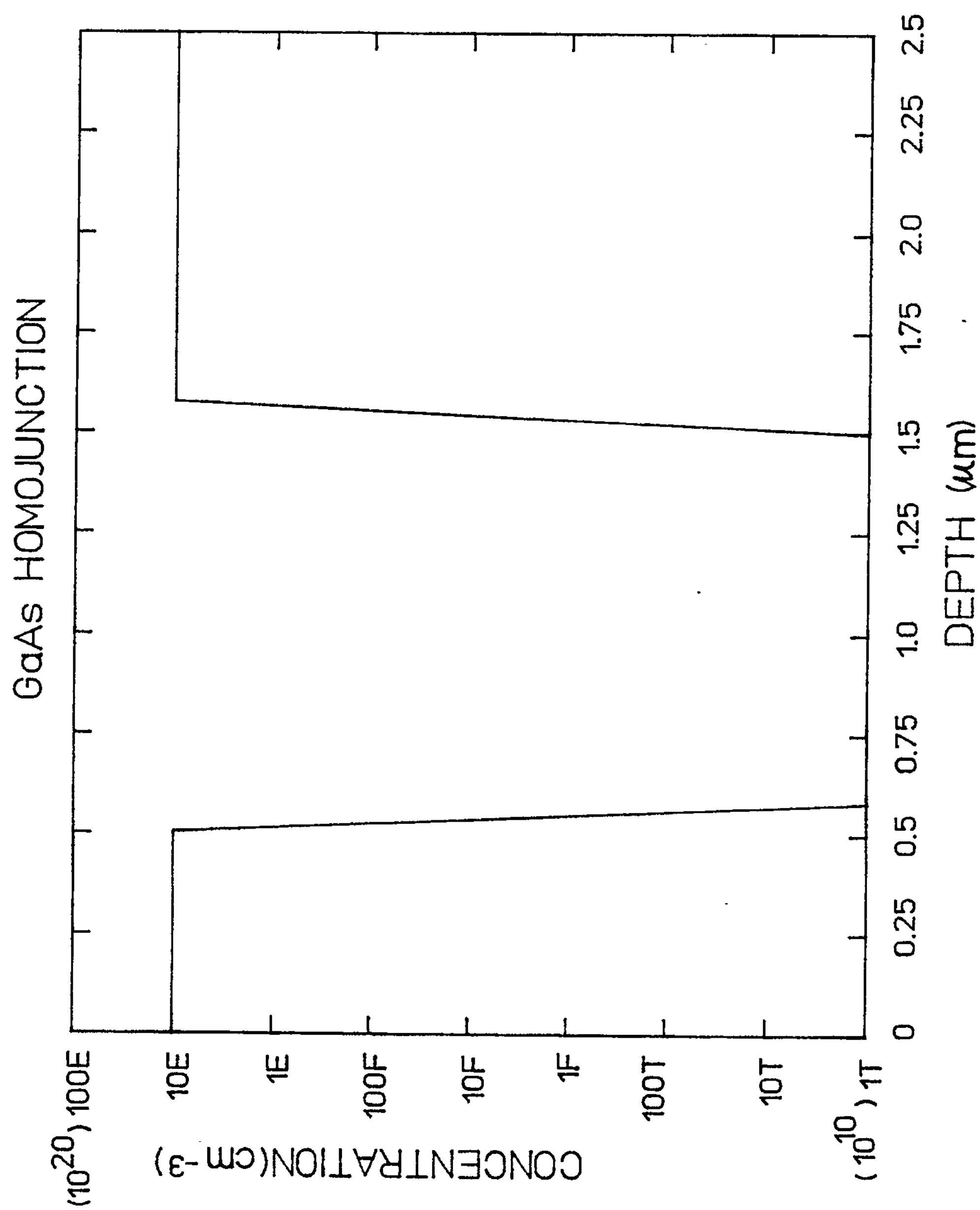
GaAs HOMOJUNCTION
CONCENTRATION(cm-3)
($10^{20}$) 100E
10E
1E
100F
10F
1F
100T
10T
($10^{10}$) 1T
0
0.25
0.5
0.75
1.0
1.25
1.5
1.75
2.0
2.25
2.5
DEPTH (μm)

FIG_ 4D

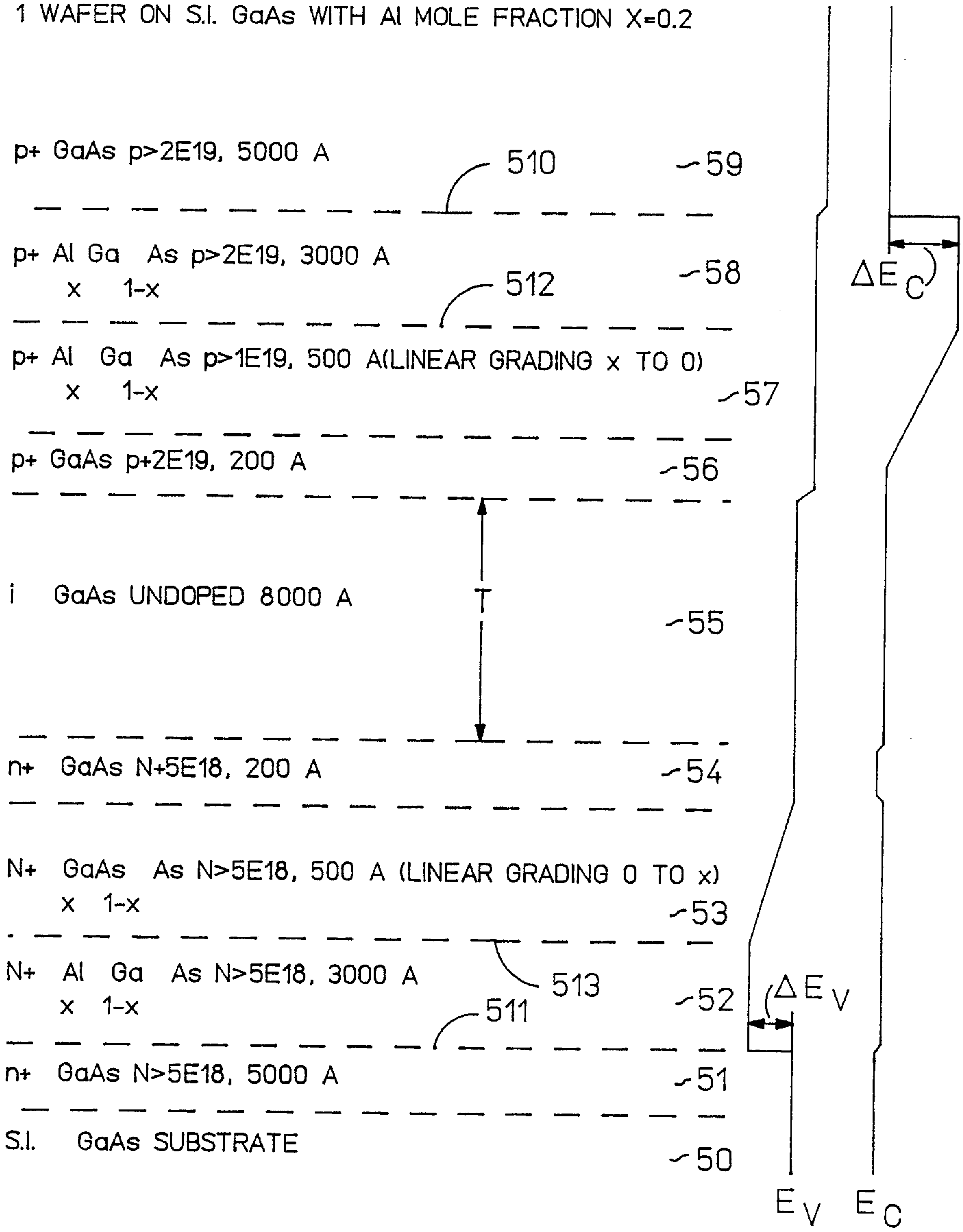
1 WAFER ON S.I. GaAs WITH Al MOLE FRACTION X=0.2
p+ GaAs p>2E19, 5000 A
510
59
p+ Al Ga As p>2E19, 3000 A
x 1-x
512
58
ΔE C
p+ Al Ga As p>1E19, 500 A(LINEAR GRADING x TO 0)
x 1-x
57
p+ GaAs p+2E19, 200 A
56
i GaAs UNDOPED 8000 A
T
55
n+ GaAs N+5E18, 200 A
54
N+ GaAs As N>5E18, 500 A (LINEAR GRADING 0 TO x)
x 1-x
53
N+ Al Ga As N>5E18, 3000 A
x 1-x
513
511
52
ΔE V
n+ GaAs N>5E18, 5000 A
51
S.I. GaAs SUBSTRATE
50
E V
E C

FIG_ 5

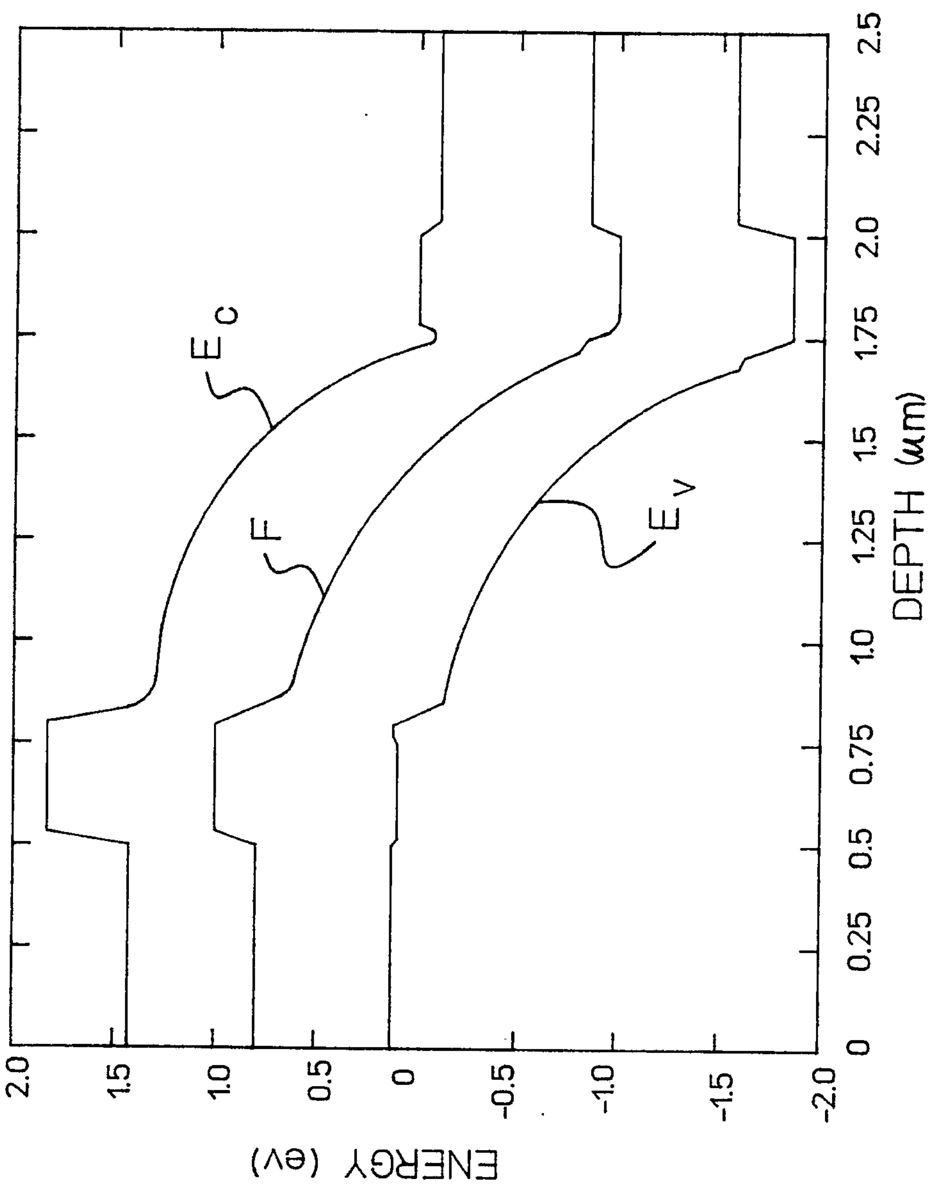


ZERO BIAS

FIG_ 6A

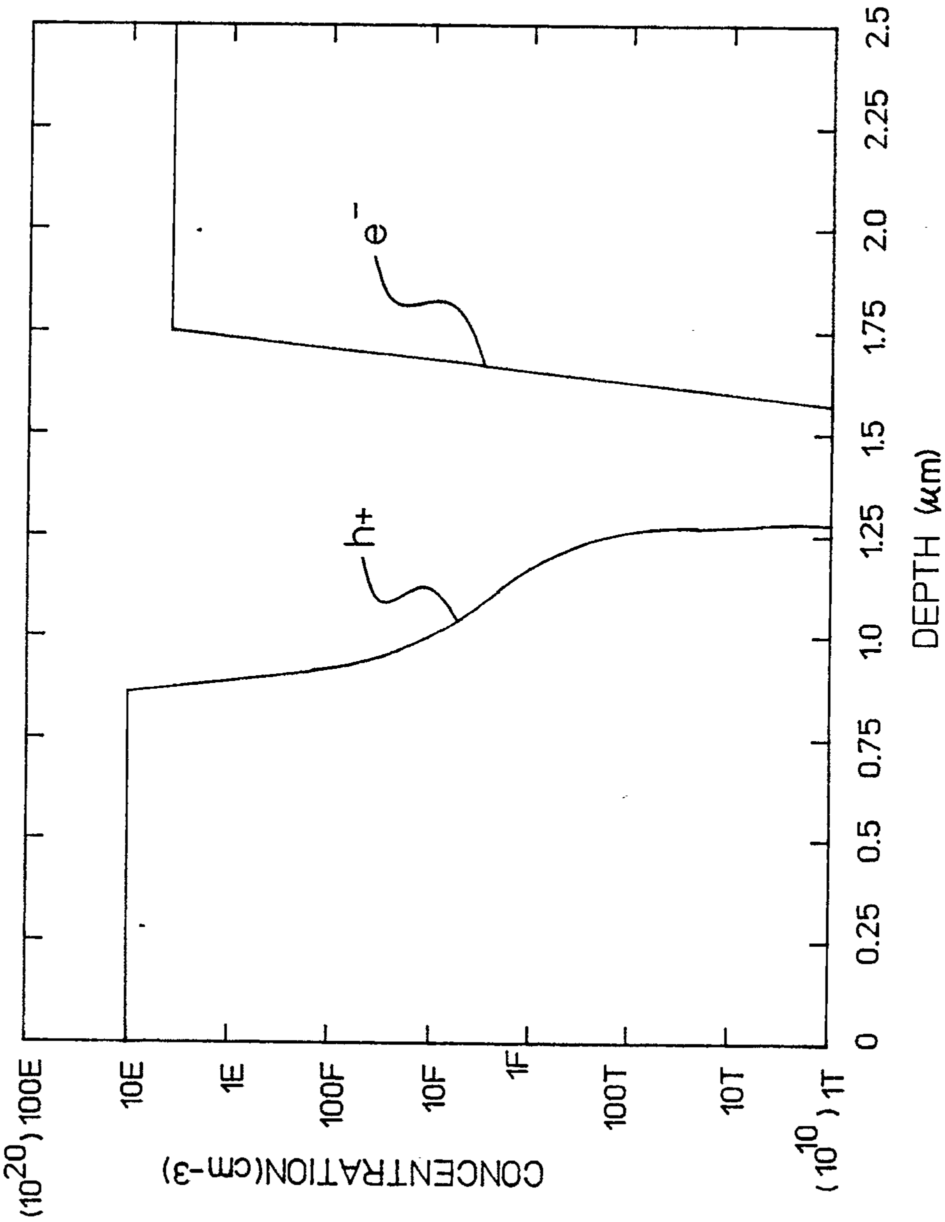


ZERO BIAS

FIG_ 6B

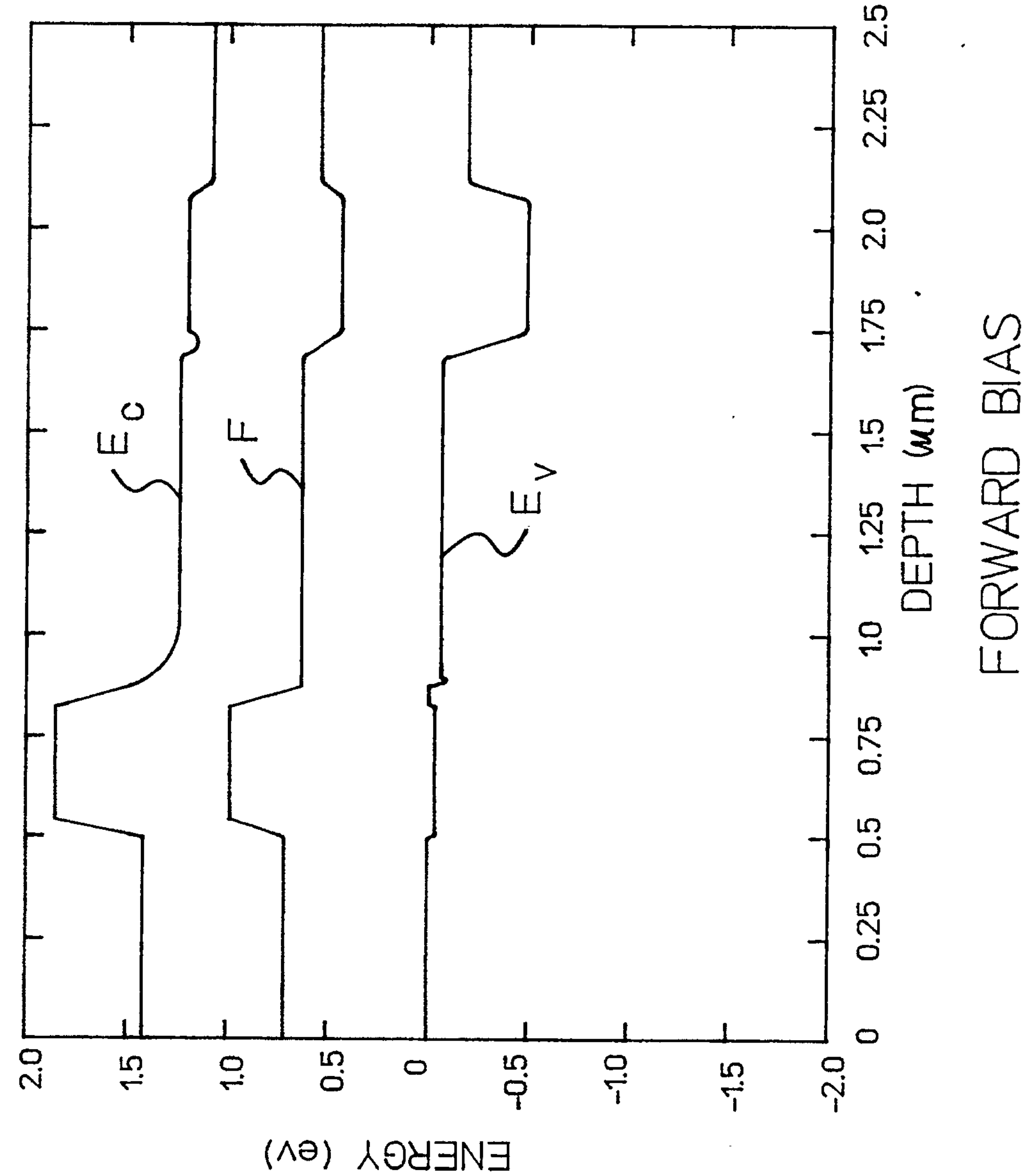
ENERGY (ev)
2.0
1.5
1.0
0.5
0
-0.5
-1.0
-1.5
-2.0
0
0.25
0.5
0.75
1.0
1.25
1.5
1.75
2.0
2.25
2.5
DEPTH (μm)
$E_c$
F
$E_v$
FORWARD BIAS

FIG_ 7A

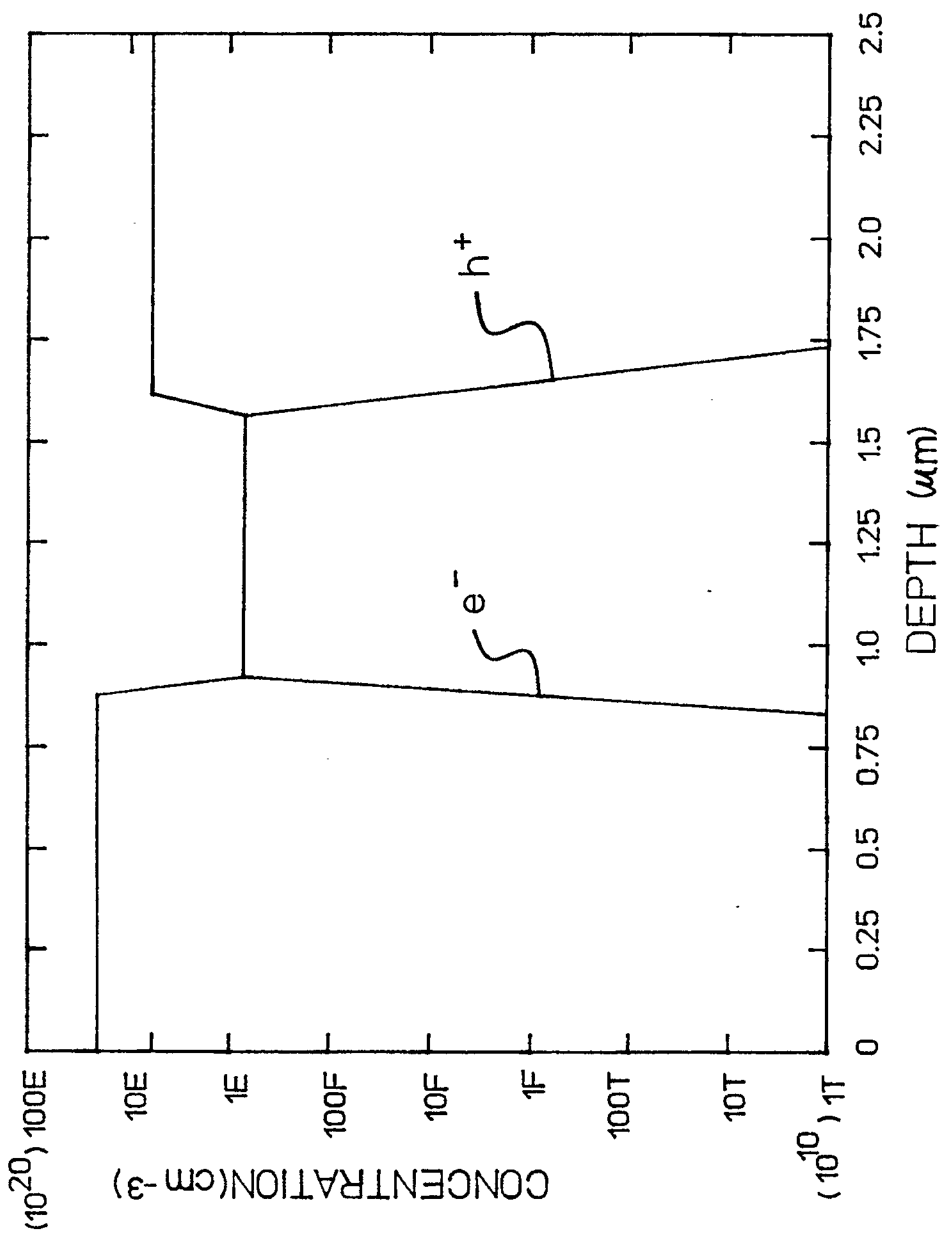


FORWARD BIAS

FIG_ 7B

FIG_ 8A

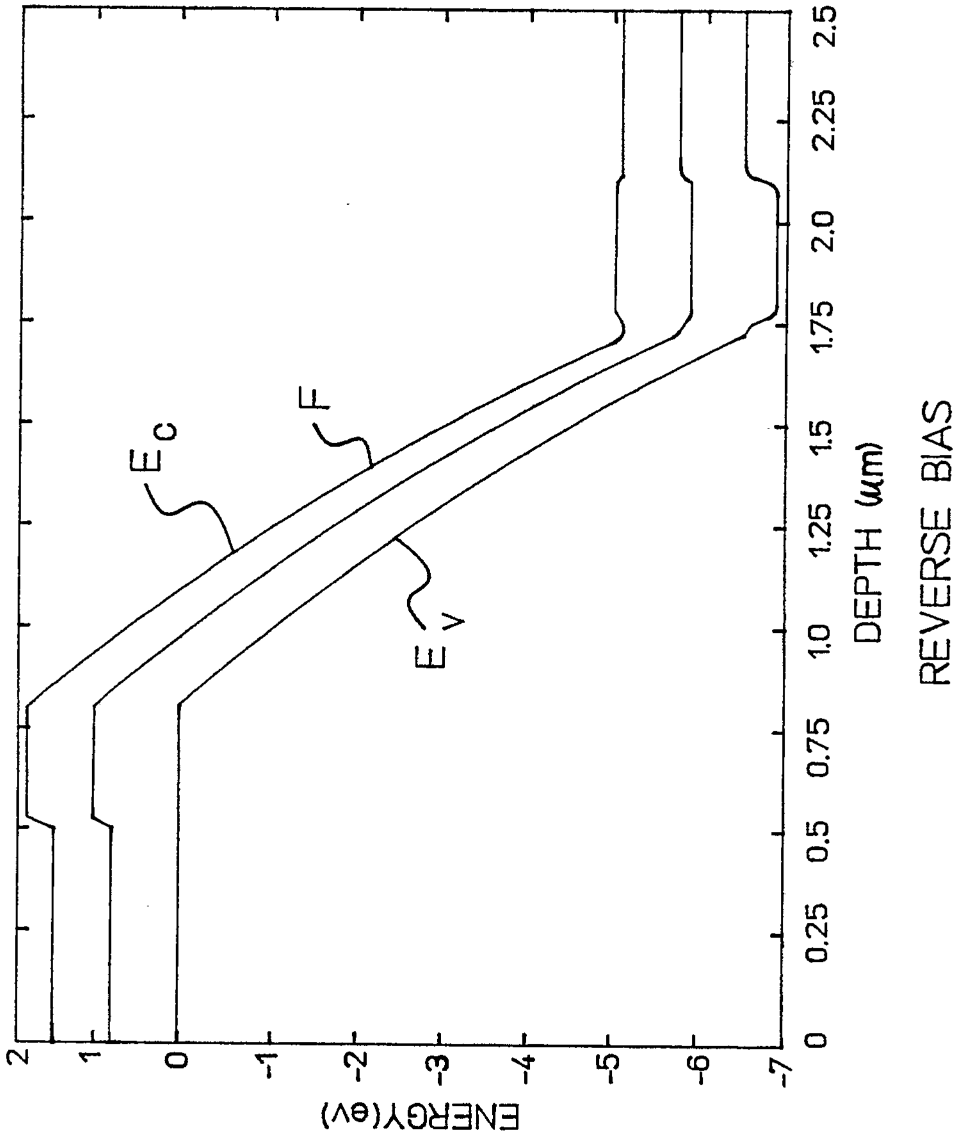

ENERGY(ev)
2
1
0
-1
-2
-3
-4
-5
-6
-7
0
0.25
0.5
0.75
1.0
1.25
1.5
1.75
2.0
2.25
2.5
DEPTH (µm)
REVERSE BIAS
$E_c$
F
$E_v$

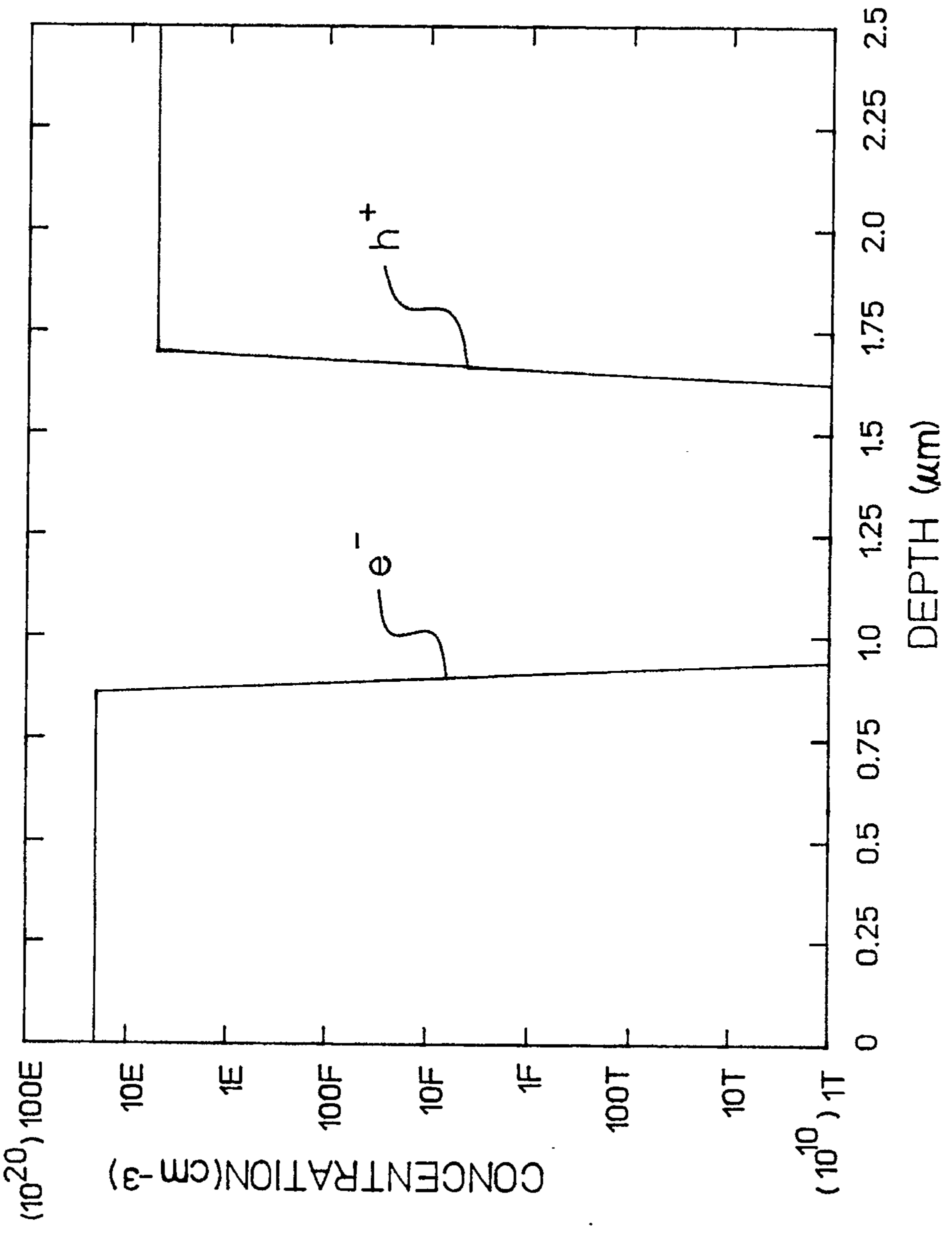


REVERSE BIAS

FIG_ 8B

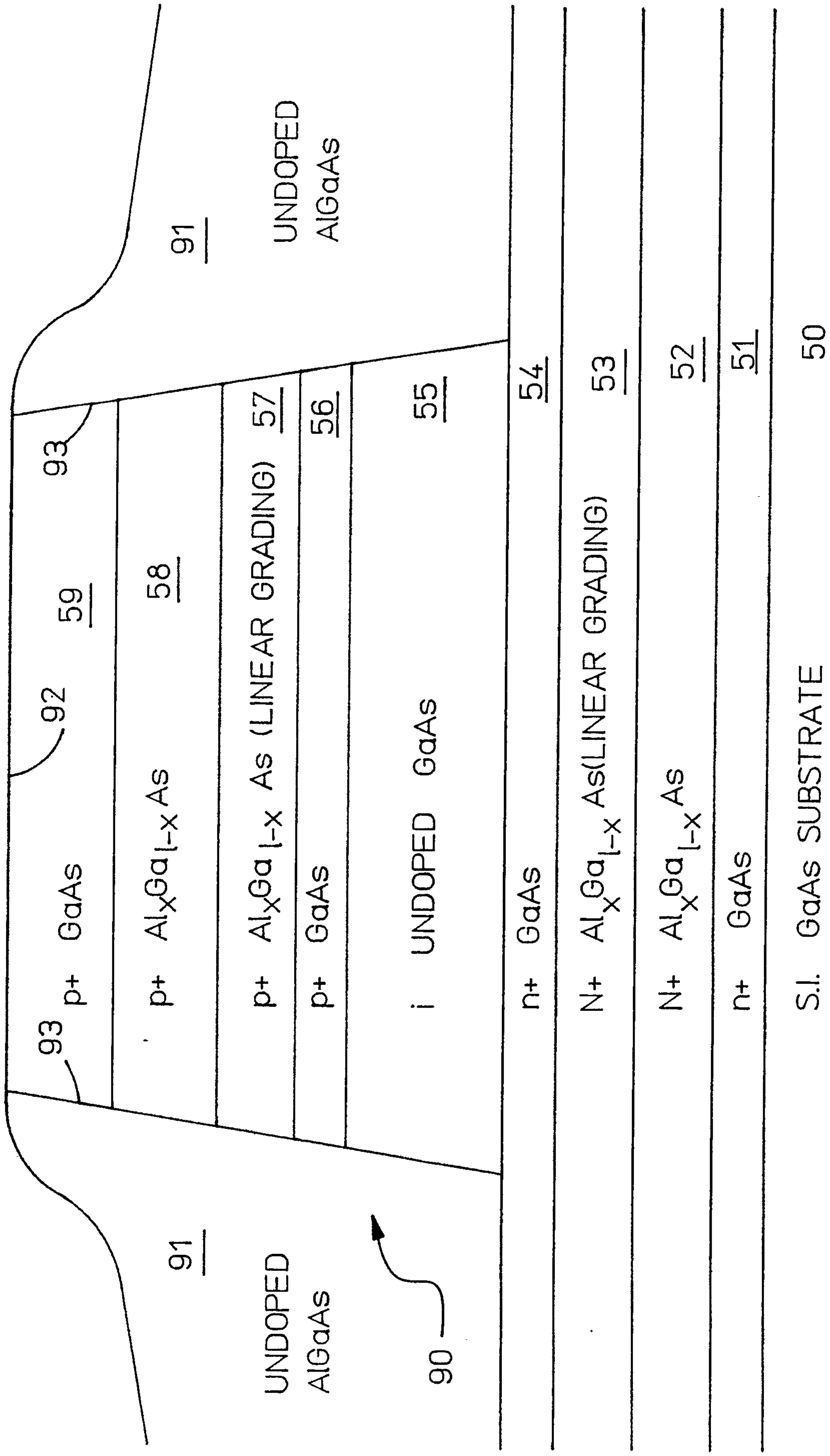
90
91
UNDOPED AlGaAs
91
UNDOPED AlGaAs
92
93
93
p+ GaAs 59
p+ $Al_xGa_{1-x}As$ 58
p+ $Al_xGa_{1-x}As$ (LINEAR GRADING) 57
p+ GaAs 56
i UNDOPED GaAs 55
n+ GaAs 54
N+ $Al_xGa_{1-x}As$(LINEAR GRADING) 53
N+ $Al_xGa_{1-x}As$ 52
n+ GaAs 51
S.I. GaAs SUBSTRATE 50

FIG_ 9

European Patent Office

# EUROPEAN SEARCH REPORT

Application Number

EP 90 11 1659

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 604 636 (CHRONAR CORP.) * column 3, lines 27 - 33 * * column 3, lines 41 - 44; figure 1 * | 1-6,11 | H 01 L 29/90 |
| A | APPLIED PHYSICS LETTERS. vol. 40, no. 10, May 1982, NEW YORK US pages 901 - 904; T.E.Zipperian: "A novel p+nn+ GaAs/Al0.30Ga0.70As/GaAs double heterojunction diode for high-temperature electronic applications." * abstract; figure 1 * | 1,2,11 | |
| A | IEEE ELECTRON DEVICE LETTERS. vol. 10, no. 7, July 1989, NEW YORK US pages 294 - 296; J.P.R.David et al.: "The electron impact ionization rate and breakdown voltage in GaAs/Ga0.7Al0.3As MQW structures." * figure 1 * | 1 | |

TECHNICAL FIELDS SEARCHED (Int. Cl.5)

H 01 L

The present search report has been drawn up for all claims

| Place of search | Date of completion of search | Examiner |
|---|---|---|
| The Hague | 27 November 90 | NILES N.P.E. |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention
E: earlier patent document, but published on, or after the filing date
D: document cited in the application
L: document cited for other reasons
&: member of the same patent family, corresponding document